# EUROPEAN PATENT APPLICATION

(11) **EP 3 996 474 A1**
(43) Date of publication of application: **11.05.2022**
(21) Application number: 20862580.6
(22) Date of filing: 03.06.2020
(51) Int. Cl.: H05K 3/46

(54) **CIRCUIT BOARD, METHOD FOR MANUFACTURING CIRCUIT BOARD, AND ELECTRONIC DEVICE**

(30) Priority: 10.09.2019 JP 2019164167
(71) Applicant: FUJITSU INTERCONNECT TECHNOLOGIES LIMITED, Nagano 381-8501 (JP)
(72) Inventor: HIRANO, Shin, Nagano-shi, Nagano 381-8501 (JP); IIDA Kenji, Nagano-shi, Nagano 381-8501 (JP); NAKAGAWA Takashi, Nagano-shi, Nagano 381-8501 (JP); TAKANO Kenji, Nagano-shi, Nagano 381-8501 (JP)
(74) Representative: Hoffmann Eitle
(86) International application number: PCT/JP2020/021855
(87) International publication number: WO 2021/049106

(57) **Abstract**

A method for manufacturing a circuit board, includes a process of obtaining a second laminated body by laminating, in this order, an uncured second insulating substrate (6) and a resin film (7) on a second surface (1B) opposite to a first surface (1A) of a cured first insulating substrate (1) of a first laminated body, and performing thermocompression bonding thereon. The first laminated body includes the first insulating substrate (1) and a metal layer (2) that is formed into a pattern shape on the first surface (1A) of the first insulating substrate (1). The method also includes a process of obtaining a third laminated body (100) by forming a hole (8) that reaches the metal layer (3), in the resin film (7), the second insulating substrate (6), and the first insulating substrate (1), from a resin film (7) side of the second laminated body, filling conductive paste (9) into the hole (8), and then peeling off the resin film (7). The method further includes a process of performing thermocompression bonding by stacking one third laminated body (100) and another third laminated body (100) in such a manner that the metal layer (2) of the one third laminated body (100) faces an opening of the hole (8) of the another third laminated body (100).

## Description

### Technical Field

The present invention relates to a circuit board, a method for manufacturing the circuit board, and an electronic device.

### Background Art

Circuit boards, such as printed circuit boards, are generally widely used heretofore in order to compactly incorporate an electronic component in an electronic device. The printed circuit board is produced by etching a copper foil adhering to a laminated plate, in accordance with an electronic circuit pattern. The printed circuit board is difficult to densely mount electronic components, but is advantageous in cost.

Meanwhile, in response to demands for smaller size, higher performance, lower price, etc., with respect to electronic devices, fining and multi-layering of electronic circuits of circuit boards, and high-density packaging of electronic components, have been rapidly progressing. Thus, multilayer printed circuit boards have been actively considered for circuit boards.

In manufacturing a multilayer printed circuit board as a circuit board having a multi-layer structure, multiple insulating substrates on which wiring patterns are formed are attached by adhesive layers. However, the adhesive layers are unnecessary in the finished multilayer printed circuit boards.

### Citation List

### Patent Literature

PTL 1: JP-A-2006-66738
PTL 2: JP-A-2009-76699
PTL 3: US-A-2011-0289774

### Summary of Invention

### Technical Problem

It is an object of the disclosed technique to provide a method for manufacturing a circuit board having a multi-layer structure, without using an adhesive layer. It is also an object of the disclosed technique to provide a circuit board having a multi-layer structure with no adhesive layer for forming the multi-layer structure, and to provide an electronic device including the circuit board.

### Solution to Problem

In one aspect, a method for manufacturing a circuit board of the disclosure includes
a process of obtaining a second laminated body by laminating, in this order, an uncured second insulating substrate and a resin film on a second surface opposite to a first surface of a cured first insulating substrate of a first laminated body, and performing thermocompression bonding thereon, the first laminated body including the first insulating substrate and a metal layer that is formed into a pattern shape on the first surface of the first insulating substrate;
a process of obtaining a third laminated body by forming a hole that reaches the metal layer, in the resin film, the second insulating substrate, and the first insulating substrate, from a resin film side of the second laminated body, filling conductive paste into the hole, and then peeling off the resin film; and
a process of performing thermocompression bonding by stacking one third laminated body and another third laminated body in such a manner that the metal layer of the one third laminated body faces an opening of the hole of the another third laminated body.

In another aspect, a circuit board of the disclosure includes
multiple laminated bodies,
each of the laminated bodies including
a cured first insulating substrate,
a metal layer being formed into a pattern shape on a first surface of the first insulating substrate,
a cured second insulating substrate being disposed on a second surface opposite to the first surface of the first insulating substrate, and
a via being formed to reach the metal layer from a surface opposite to a first insulating substrate side of the second insulating substrate,
among the multiple laminated bodies, one laminated body and another laminated body being positioned in such a manner that the metal layer of the one laminated body faces the via that is exposed at the surface of the second insulating substrate of the another laminated body.

In another aspect, an electronic device of the disclosure includes the disclosed circuit board and an electronic component.

### Advantageous Effects of Invention

According to one aspect, it is possible to provide a method for manufacturing a circuit board having a multi-layer structure, without using an adhesive layer.

According to another aspect, it is possible to provide a circuit board having a multi-layer structure with no adhesive layer for forming the multi-layer structure.

According to another aspect, it is possible to provide an electronic device using a circuit board that has a multi-layer structure with no adhesive layer for forming the multi-layer structure.

### Brief Description of Drawings

Fig. 1 is a schematic sectional view for explaining an example of a method for manufacturing a circuit board (Part 1).
Fig. 2 is a schematic sectional view for explaining the example of the method for manufacturing the circuit board (Part 2).
Fig. 3 is a schematic sectional view for explaining the example of the method for manufacturing the circuit board (Part 3).
Fig. 4 is a schematic sectional view for explaining the example of the method for manufacturing the circuit board (Part 4).
Fig. 5 is a schematic sectional view for explaining the example of the method for manufacturing the circuit board (Part 5).
Fig. 6 is a schematic sectional view for explaining the example of the method for manufacturing the circuit board (Part 6).
Fig. 7 is a schematic sectional view for explaining the example of the method for manufacturing the circuit board (Part 7).
Fig. 8 is a schematic sectional view for explaining the example of the method for manufacturing the circuit board (Part 8).
Fig. 9 is a schematic sectional view for explaining the example of the method for manufacturing the circuit board (Part 9).
Fig. 10 is a schematic sectional view for explaining the example of the method for manufacturing the circuit board (Part 10).
Fig. 11 is a schematic sectional view for explaining the example of the method for manufacturing the circuit board (Part 11).
Fig. 12 is a schematic sectional view of a semiconductor package.

### Description of Embodiments

### (Method for Manufacturing Circuit Board)

A disclosed method for manufacturing a circuit board includes at least a process of obtaining a second laminated body, a process of obtaining a third laminated body, and a process of thermocompression bonding, and it can further include other processes as necessary.

### <Process of Obtaining Second Laminated Body>

The second laminated body is obtained by laminating, in this order, an uncured second insulating substrate and a resin film on a second surface opposite to a first surface of a first insulating substrate of a first laminated body, and performing thermocompression bonding thereon.

### «First Laminated Body»

The first laminated body includes a cured first insulating substrate and a metal layer formed into a pattern shape on the first surface of the first insulating substrate.

### <<<First Insulating Substrate>>>

The first insulating substrate is in a cured state.

The first insulating substrate is not specifically limited on the condition that it is an insulating substrate being able to be used in a circuit board, and it can be appropriately selected in accordance with the purpose. An example of the first insulating substrate includes a substrate that is hardened by an inorganic substrate such as an inorganic woven fabric or an inorganic nonwoven fabric, or an organic substrate such as an organic woven fabric or an organic nonwoven fabric, each which uses a glass cloth or the like.

More specifically, examples of the first insulating substrate include glass epoxy substrates (glass woven fabric substrate impregnated with epoxy resin and glass nonwoven fabric substrate impregnated with epoxy resin), a glass woven fabric substrate impregnated with bismaleimide-triazine resin, an aramid nonwoven fabric substrate impregnated with epoxy resin, and a glass woven fabric substrate impregnated with modified polyphenylene ether resin.

The glass epoxy substrate is a substrate that is obtained by impregnating epoxy resin into a glass fiber fabric (woven fabric or nonwoven fabric).

The first insulating substrate is in a cured state. The cured state is, for example, a state in which approximately 100 % of the total curing heat is generated, in other words, a state in which almost no heat generation can be observed in differential scanning calorimetry. Hereinafter, the cured state may be referred to as a "C stage". In addition, the degree of curing not reaching the C stage may be referred to as a "B stage".

The first insulating substrate usually has a sheet shape.

An average thickness of the first insulating substrate is not specifically limited and can be appropriately selected in accordance with the purpose. In one example, this average thickness may be 10 µm or greater and 200 µm or less, or 30 µm or greater and 100 µm or less.

### «<Metal Layer»>

The metal for forming the metal layer is not specifically limited and can be appropriately selected in accordance with the purpose. Examples of the metal include nickel and copper.

The metal layer may have a single-layer structure or a multi-layer structure. The metal layer has, for example, a copper single layer structure or a two-layer structure of a copper layer and a nickel layer.

The pattern of the metal layer is not specifically limited and can be appropriately selected in accordance with the purpose.

The method for forming the metal layer into a pattern shape is not specifically limited and can be appropriately selected in accordance with the purpose. Examples of this method include a subtractive (etching) method and a semiadditive method (plating method). These can be conducted by using a photolithography method.

A surface opposite to the first insulating substrate side of the metal layer is preferably a rough surface. The rough surface opposite to the first insulating substrate side of the metal layer improves adhesion between one third laminated body and another third laminated body in thermocompression bonding. Moreover, in performing thermocompression bonding on one third laminated body that is stacked on another third laminated body in such a manner that the metal layer of the one third laminated body faces an opening of the hole of the another third laminated body, the rough surface opposite to the first insulating substrate side of the metal layer suppresses excessive spread of conductive paste that protrudes from the hole. This results in favorable electrical connection between the metal layer and a via that is made of the conductive paste.

The method for roughening the surface of the metal layer is not specifically limited and can be appropriately selected in accordance with the purpose. An example of this method includes a CZ process (treatment of copper surface of zigzag). In one example, an arithmetic average roughness (Ra) of the rough surface is 1.0 µm or greater and 2.0 µm or less.

An average thickness of the metal layer is not specifically limited and can be appropriately selected in accordance with the purpose. In one example, this average thickness may be 5 µm or greater and 40 µm or less, or 10 µm or greater and 30 µm or less.

### «Second Insulating Substrate»

The second insulating substrate is in an uncured state.

The second insulating substrate is not specifically limited on the condition that it is an insulating substrate being able to be used in a circuit board, and it can be appropriately selected in accordance with the purpose. An example of the second insulating substrate includes a substrate that is hardened by an inorganic substrate such as an inorganic woven fabric or an inorganic nonwoven fabric, or an organic substrate such as an organic woven fabric or an organic nonwoven fabric, each which uses a glass cloth or the like.

More specifically, examples of the second insulating substrate include glass epoxy substrates (glass woven fabric substrate impregnated with epoxy resin and glass nonwoven fabric substrate impregnated with epoxy resin), a glass woven fabric substrate impregnated with bismaleimide-triazine resin, an aramid nonwoven fabric substrate impregnated with epoxy resin, and a glass woven fabric substrate impregnated with modified polyphenylene ether resin.

The glass epoxy substrate is a substrate that is obtained by impregnating epoxy resin into a glass fiber fabric (woven fabric or nonwoven fabric).

The glass epoxy substrate as the first insulating substrate and the glass epoxy substrate as the second insulating substrate are preferably the same glass epoxy substrates. This reduces, for example, occurrence of warp of the circuit board due to difference in stress, because characteristic values (such as volume shrinkage/expansion, and mechanical rigidity) are the same. In addition, this eliminates effects on curing, bonding condition, and so on, caused by transferring of material components and moisture contained in the substrate, into the adjacent substrate.

Herein, the same glass epoxy substrates exhibit the same characteristics in the cured (C stage) state. For example, in a case in which a glass epoxy substrate that is the same as the glass epoxy substrate in the C stage as the first insulating substrate, is used in a state of the B stage as the second insulating substrate, they are the same glass epoxy substrates.

The material of the second insulating substrate may be thermosetting resin. Fluorocarbon resin, polyphenylene ether resin (PPE/PPO resin), polyimide resin (PI resin), and bismaleimide-triazine resin (BT resin) are preferable as the thermosetting resin. These resins have low dielectric constants and low dielectric loss tangents, and therefore, they reduce transmission loss of electrical signals.

The second insulating substrate usually has a sheet shape.

An average thickness of the second insulating substrate is not specifically limited and can be appropriately selected in accordance with the purpose. In one example, this average thickness may be 10 µm or greater and 150 µm or less, or 20 µm or greater and 100 µm or less.

The ratio of the average thickness of the first insulating substrate and the average thickness of the second insulating substrate (first insulating substrate: second insulating substrate) is not specifically limited and can be appropriately selected in accordance with the purpose. From the point of view of manufacturability of the circuit board and thickness control, 4.0:1.0 to 1.0:1.0 is preferable, and 2.0:1.0 to 1.5:1.0 is more preferable.

### «Resin Film»

The resin film is not specifically limited on the condition that it does not melt at the time of thermocompression bonding, and it can be appropriately selected in accordance with the purpose. Examples of the resin film include a polyethylene terephthalate film, a polyethylene naphthalate film, a polyphenylene sulfide film, and a polyimide film.

A surface on the second insulating substrate side of the resin film is preferably a rough surface. This further enhances temporal adhesion between the second insulating substrate and the resin film after thermocompression bonding, whereby unintentional peeling off between the second insulating substrate and the resin film is avoided in other processes.

The method for roughening the surface of the resin film is not specifically limited and can be appropriately selected in accordance with the purpose. Examples of this method include blasting, embossing, and coating. In one example, an arithmetic average roughness (Ra) of this rough surface is 1.0 µm or greater and 2.0 µm or less.

The average thickness of the resin film is not specifically limited and can be appropriately selected in accordance with the purpose. In one example, this average thickness is 10 µm or greater and 100 µm or less.

The process of obtaining the second laminated body includes laminating, in this order, the uncured second insulating substrate and the resin film on a second surface opposite to the first surface of the first insulating substrate of the first laminated body, and performing thermocompression bonding thereon. This enables temporal adhesion between the first laminated body and the second insulating substrate and temporal adhesion between the second insulating substrate and the resin film.

Unlike an adhesive layer, the second insulating substrate does not have sufficient adhesive properties under normal temperature and normal pressure. For this reason, unless thermocompression bonding is performed, temporal adhesion between the first laminated body and the second insulating substrate is insufficient, and the first laminated body and the second insulating substrate may be peeled off from each other in other processes. In addition, unless thermocompression bonding is performed, temporal adhesion between the second insulating substrate and the resin film is insufficient, and the second insulating substrate and the resin film may be peeled off from each other in other processes.

That is, thermocompression bonding is preferably performed in order to prevent the first laminated body and the second insulating substrate from peeling off from each other and to prevent the second insulating substrate and the resin film from peeling off from each other unintentionally.

Temperature, pressure, and time period of the thermocompression bonding are not specifically limited and can be appropriately selected in accordance with the purpose.

In one example, the temperature is 50 °C or higher and 100 °C or lower.

In one example, the pressure is 0.5 MPa or higher and 1.2 MPa or lower.

In one example, the time period is 60 seconds or longer and 120 seconds or shorter.

The thermocompression bonding is preferably performed so as to cure, but not completely cure, the second insulating substrate. That is, the thermocompression bonding is preferably performed so as not to cure the second insulating substrate to the C stage. Forming holes in the cured second insulating substrate improves stability of dimensions of the holes. In another case, the circuit board may be manufactured by performing thermocompression bonding on multiple third laminated bodies that are stacked on one another before the second insulating substrates are completely cured. In this case, adhesive properties between the second insulating substrate of one third laminated body and the first insulating substrate of another third laminated body is excellent. In yet another case, thermocompression bonding may be performed on multiple third laminated bodies that are stacked on one another before the second insulating substrates are completely cured. In this case, the metal layer of one third laminated body is easily embedded into the second insulating substrate of another third laminated body, whereby a circuit board having a uniform thickness is obtained.

### <Process of Obtaining Third Laminated Body>

The third laminated body is obtained as follows: forming a hole that reaches the metal layer, in the resin film, the second insulating substrate, and the first insulating substrate, from the resin film side of the second laminated body, filling conductive paste into the hole, and then peeling off the resin film.

### «Hole (Via Hole)»

The method of forming the hole (via hole) is not specifically limited and can be appropriately selected in accordance with the purpose. An example of this method includes a method of forming a hole by using laser.

The laser is not specifically limited and can be appropriately selected in accordance with the purpose. Examples of the laser include CO₂ laser and YAG laser.

Output of the laser is not specifically limited and can be appropriately selected in accordance with the purpose.

The size (opening diameter) of the hole is not specifically limited on the condition that the hole exposes a surface on the first insulating substrate side of the metal layer, and it can be appropriately selected in accordance with the purpose. In one example, this size may be 50 µm or larger and 500 µm or smaller, or 100 µm or larger and 300 µm or smaller.

Herein, the size (opening diameter) of the hole represents, for example, an opening diameter at a surface on the resin film side of the second insulating substrate.

The shape of the hole is not specifically limited and can be appropriately selected in accordance with the purpose. An example of this shape includes a shape (tapered shape) in which the diameter of the hole gradually decreases as it goes from the opening on the resin film side to the metal layer.

The number of the holes that are formed in the second laminated body is not specifically limited and can be appropriately selected in accordance with the purpose.

### «Conductive Paste»

The conductive paste is not specifically limited and can be appropriately selected in accordance with the purpose. An example of the conductive paste includes conductive paste containing metal particles (conductive filler) and binder resin.

The metal for composing the metal particles is, for example, copper, gold, silver, palladium, nickel, tin, lead, or bismuth. These elements may be used alone or in combination of two or more.

The binder resin is, for example, thermosetting resin such as epoxy resin. However, the binder resin is not limited to this and may be another resin such as polyimide resin.

The binder resin may be liquid or solid at ordinary temperatures. In a case in which the binder resin is solid at ordinary temperatures, for example, the conductive paste is heated to a temperature at or higher than a melting temperature of the binder resin when in use.

The conductive paste can be obtained by kneading the binder resin and the metal particles, for example. The conductive paste may contain flux.

The conductive paste may be of a pressure welding type or a melting type.

As to the conductive paste of pressure welding type, low-resistance metal particles (conductive filler) do not melt by heat in laminating, but the conductive fillers come into contact with each other only by pressure in laminating and enables conduction connection between layers. The conductive paste of pressure welding type loses fluidity in response to thermal curing of resin contained in the conductive paste.

As to the conductive paste of melting type, low-melting point metal particles (conductive filler) melt by heat in laminating, and they are cured in such a manner as to surround high-melting point metal particles (conductive filler) to form an alloy layer, which enables conduction connection between layers.

The method of filling the conductive paste into the hole is not specifically limited and can be appropriately selected in accordance with the purpose. An example of this method includes a method of filling the conductive paste into the hole by using a squeegee jig under the air atmosphere or vacuum.

### «Peeling»

The method of peeling off the resin film is not specifically limited and can be appropriately selected in accordance with the purpose. An example of this method includes a method of pinching an end of the resin film by a jig and peeling it off the second insulating substrate.

### <Process of Thermocompression Bonding>

Thermocompression bonding is performed by stacking one third laminated body and another third laminated body in such a manner that the metal layer of the one third laminated body faces an opening of the hole of the another third laminated body.

Temperature, pressure, and time period of the thermocompression bonding are not specifically limited and can be appropriately selected in accordance with the purpose.

In one example, the temperature is 200 °C or higher and 500 °C or lower.

In one example, the pressure is 2 MPa or higher and 10 MPa or lower.

In one example, the time period is 3 hours or longer and 5 hours or shorter.

The thermocompression bonding is preferably performed so as to completely cure the second insulating substrate. That is, the thermocompression bonding is preferably performed so as to cure the second insulating substrate to the C stage. In this manner, a circuit board is provided.

### <Other Processes>

Other processes include a process of curing a surface of the conductive paste, for example.

### «Process of Curing Surface of Conductive Paste»

The method for manufacturing the circuit board preferably involves a process of curing a surface of the conductive paste that protrudes from the hole of the third laminated body.

Curing the surface of the conductive paste that protrudes from the hole enables maintaining the shape of the conductive paste that protrudes from the hole. Moreover, curing the surface of the conductive paste that protrudes from the hole enables avoiding unfavorable flow and spread of the conductive paste in performing thermocompression bonding on one third laminated body and another third laminated body that are stacked on one another.

The degree of curing is not specifically limited and can be appropriately selected in accordance with the purpose, and complete curing may not be performed.

The heating method is not specifically limited and can be appropriately selected in accordance with the purpose.

### (Circuit Board)

The disclosed circuit board includes multiple laminated bodies.

Among the multiple laminated bodies of the circuit board, one laminated body and another laminated body are positioned in such a manner that a metal layer of the one laminated body faces a via that is exposed at the surface of a second insulating substrate of the another laminated body.

The disclosed circuit board is manufactured, for example, by the disclosed method for manufacturing the circuit board.

### <Laminated Body>

The laminated body includes a first insulating substrate, a metal layer, a second insulating substrate, and a via.

### «First Insulating Substrate»

The first insulating substrate is in a cured state. That is, the first insulating substrate is in the C stage.

The first insulating substrate is not specifically limited on the condition that it is an insulating substrate being able to be used in a circuit board, and it can be appropriately selected in accordance with the purpose. An example of the first insulating substrate includes a substrate that is hardened by an inorganic substrate such as an inorganic woven fabric or an inorganic nonwoven fabric, or an organic substrate such as an organic woven fabric or an organic nonwoven fabric, each which uses a glass cloth or the like.

More specifically, examples of the first insulating substrate include glass epoxy substrates (glass woven fabric substrate impregnated with epoxy resin and glass nonwoven fabric substrate impregnated with epoxy resin), a glass woven fabric substrate impregnated with bismaleimide-triazine resin, an aramid nonwoven fabric substrate impregnated with epoxy resin, and a glass woven fabric substrate impregnated with modified polyphenylene ether resin.

The glass epoxy substrate is a substrate that is obtained by impregnating epoxy resin into a glass fiber fabric (woven fabric or nonwoven fabric).

The first insulating substrate usually has a sheet shape.

An average thickness of the first insulating substrate is not specifically limited and can be appropriately selected in accordance with the purpose. In one example, this average thickness may be 10 µm or greater and 200 µm or less, or 30 µm or greater and 100 µm or less.

### «Metal Layer»

The metal layer is formed into a pattern shape on a first surface of the first insulating substrate.

The metal for forming the metal layer is not specifically limited and can be appropriately selected in accordance with the purpose. Examples of the metal include nickel and copper.

The metal layer may have a single-layer structure or a multi-layer structure. The metal layer has, for example, a copper single layer structure or a two-layer structure of a copper layer and a nickel layer.

The pattern of the metal layer is not specifically limited and can be appropriately selected in accordance with the purpose.

The method for forming the metal layer into a pattern shape is not specifically limited and can be appropriately selected in accordance with the purpose. Examples of this method include a subtractive (etching) method and a semiadditive method (plating method). These can be conducted by using a photolithography method.

An average thickness of the metal layer is not specifically limited and can be appropriately selected in accordance with the purpose. In one example, this average thickness may be 5 µm or greater and 40 µm or less, or 10 µm or greater and 30 µm or less.

### «Second Insulating Substrate»

In the circuit board, the second insulating substrate is in a cured state. That is, the second insulating substrate is in the C stage in the circuit board.

The second insulating substrate is not specifically limited on the condition that it is an insulating substrate being able to be used in a circuit board, and it can be appropriately selected in accordance with the purpose. An example of the second insulating substrate includes a substrate that is hardened by an inorganic substrate such as an inorganic woven fabric or an inorganic nonwoven fabric, or an organic substrate such as an organic woven fabric or an organic nonwoven fabric, each which uses a glass cloth or the like.

More specifically, examples of the second insulating substrate include glass epoxy substrates (glass woven fabric substrate impregnated with epoxy resin and glass nonwoven fabric substrate impregnated with epoxy resin), a glass woven fabric substrate impregnated with bismaleimide-triazine resin, an aramid nonwoven fabric substrate impregnated with epoxy resin, and a glass woven fabric substrate impregnated with modified polyphenylene ether resin.

The glass epoxy substrate is a substrate that is obtained by impregnating epoxy resin into a glass fiber fabric (woven fabric or nonwoven fabric).

The glass epoxy substrate as the first insulating substrate and the glass epoxy substrate as the second insulating substrate are preferably the same glass epoxy substrates. This reduces, for example, occurrence of warp of the circuit board due to difference in stress because characteristic values (such as volume shrinkage/expansion, and mechanical rigidity) are the same. In addition, this eliminates effects on curing, bonding condition, and so on, caused by transferring of material components and moisture contained in the substrate, into the adjacent substrate.

Herein, the same glass epoxy substrates exhibit the same characteristics in the cured (C stage) state. For example, in a case in which a glass epoxy substrate that is the same as the glass epoxy substrate in the C stage as the first insulating substrate, is used in a state of the B stage as the second insulating substrate, they are the same glass epoxy substrates.

The material of the second insulating substrate may be a cured substance of thermosetting resin. Fluorocarbon resin, polyphenylene ether resin (PPE/PPO resin), polyimide resin (PI resin), and bismaleimide-triazine resin (BT resin) are preferable as the thermosetting resin. These resins have low dielectric constants and low dielectric loss tangents, and therefore, they reduce transmission loss of electrical signals.

The second insulating substrate usually has a sheet shape.

An average thickness of the second insulating substrate is not specifically limited and can be appropriately selected in accordance with the purpose. In one example, this average thickness may be 10 µm or greater and 150 µm or less, or 20 µm or greater and 100 µm or less.

The ratio of the average thickness of the first insulating substrate and the average thickness of the second insulating substrate (first insulating substrate: second insulating substrate) is not specifically limited and can be appropriately selected in accordance with the purpose. From the point of view of manufacturability of the circuit board and thickness control, 4.0:1.0 to 1.0:1.0 is preferable, and 2.0:1.0 to 1.5:1.0 is more preferable.

### <<Via>>

The via is formed to reach the metal layer from a surface opposite to the first insulating substrate side of the second insulating substrate.

The via is made by forming a conductor in a formed hole in order to electrically connect the laminated bodies of the circuit board. The conductor is not specifically limited and can be appropriately selected in accordance with the purpose. Examples of the conductor include a cured substance of conductive paste and plating.

In the case in which the conductor is a cured substance of conductive paste, normally, the via is formed by filling the conductive paste into the whole hole and curing this conductive paste.

In the case in which the conductor is plating, normally, the via is formed by electroplating or electroless plating on an inner wall of a hole.

The conductive paste is not specifically limited and can be appropriately selected in accordance with the purpose. An example of the conductive paste includes the conductive paste that is described in the disclosed method for manufacturing the circuit board.

### (Electronic Device)

The disclosed electronic device includes at least the disclosed circuit board and an electronic component, and moreover includes other components as necessary.

The electronic device is not specifically limited and can be appropriately selected in accordance with the purpose. Examples of the electronic device include personal computers (laptop computer and desktop computer), a telephone, a cellular phone, a tablet portable terminal, a smart phone, a copying machine, a facsimile, each kind of printers, a digital camera, a television, a video machine, a CD machine, a DVD machine, an air conditioner, and a remote controller.

An example of the disclosed method for manufacturing the circuit board will be described below by using the drawings.

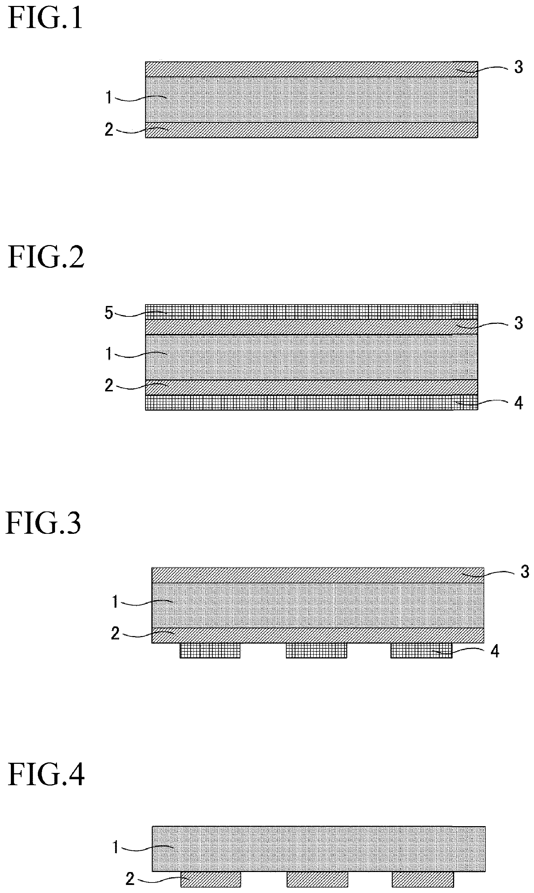

First, a double-sided copper clad substrate in which metal layers 2, 3 of copper foil adhere on both surfaces of a first insulating substrate 1, is prepared (Fig. 1). The first insulating substrate 1 is, for example, a cured glass epoxy substrate, and has an average thickness of 60 µm, for example. The average thickness of the metal layers 2, 3 is, for example, 15 µm.

Next, dry film resists 4, 5 are attached on both surfaces of the double-sided copper clad substrate by using a laminator (Fig. 2).

Then, the dry film resist 4 is subjected to selective exposure and development, whereby a resist pattern for producing a pattern-shaped metal layer is formed (Fig. 3). On the other hand, the dry film resist 5 on the whole surface is dissolved by development. The dry film resists 4, 5 are not specifically limited and can be appropriately selected in accordance with the purpose. Examples of the dry film resists 4, 5 include positive dry film resist and negative dry film resist. An exposure wavelength in selective exposure is not specifically limited on the condition that it enables exposing the dry film resist, and it can be appropriately selected in accordance with the purpose. The method of development is not specifically limited and can be appropriately selected in accordance with the purpose. An example of this method includes development using an alkaline solution.

Thereafter, the metal layers 2, 3 are etched by using the patterned dry film resist 4 as a mask, whereby the patterned metal layer 2 is obtained (Fig. 4). An example of the etching method includes wet etching.

The above processes provide a first laminated body.

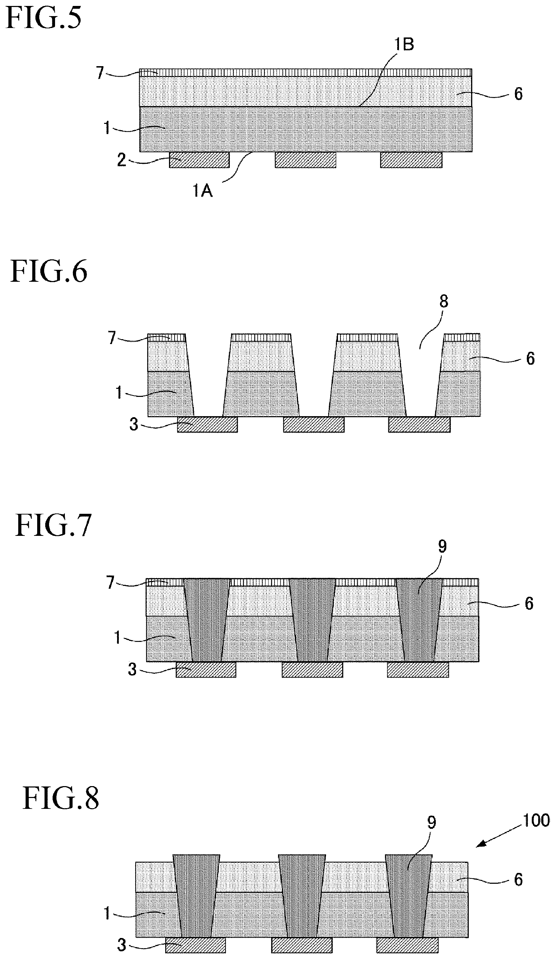

Next, an uncured second insulating substrate 6 and a resin film 7 are laminated, in this order, on a second surface 1B opposite to a first surface 1A of the first insulating substrate 1 of the first laminated body, and they are subjected to thermocompression bonding, whereby a second laminated body is obtained (Fig. 5). The second insulating substrate 6 before thermocompression bonding is, for example, a glass epoxy substrate in the B stage. The thermocompression bonding is preferably performed so as to thermally cure the second insulating substrate 6. Note that the thermal curing is preferably performed in such a degree as to appropriately proceed the degree of curing in the B stage, instead of thermally curing to the C stage.

Then, a hole 8 that reaches the metal layer 3 is formed in the resin film 7, the second insulating substrate 6, and the first insulating substrate 1, from the resin film 7 side of the second laminated body (Fig. 6). The hole 8 can be formed by emitting laser, for example.

Thereafter, a conductive paste 9 is filled into the hole 8 (Fig. 7). The method of filling the conductive paste 9 into the hole 8 is not specifically limited and can be appropriately selected in accordance with the purpose. An example of this method includes a method of filling the conductive paste into the hole by using a squeegee jig under the air atmosphere or vacuum.

Then, the resin film 7 is peeled off (Fig. 8). Thus, the conductive paste 9 protrudes from an opening of the second insulating substrate 6 by the thickness of the resin film 7.

The above processes provide a third laminated body 100.

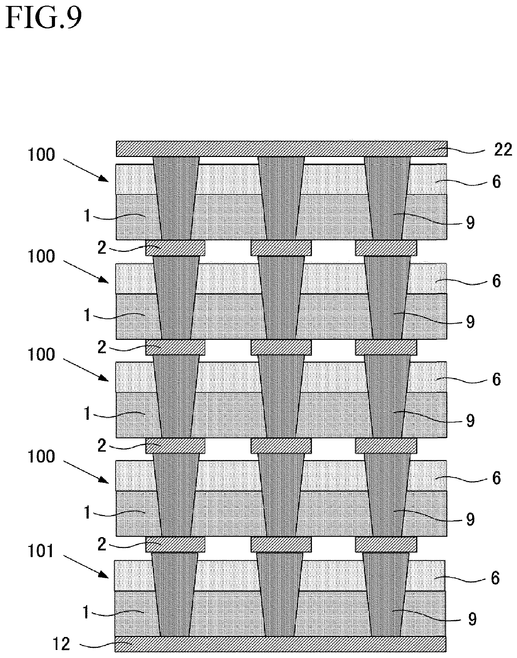

Next, with respect to multiple third laminated bodies 100, one third laminated body 100 and another third laminated body 100 are stacked in such a manner that the metal layer 2 of the one third laminated body 100 faces the opening of the hole 8 of the another third laminated body 100 (Fig. 9). At this time, a non-patterned metal layer is preferably provided on the top and the bottom of the laminate composed of the stacked multiple laminated bodies. In one example, a non-patterned metal layer 22 is overlaid on the top of the uppermost third laminated body 100. A laminated body that is composed of the third laminated body 100 without the patterned metal layer 2 is used as a lowermost laminated body 101. A metal layer 12 is disposed on the bottom of this laminated body 101.

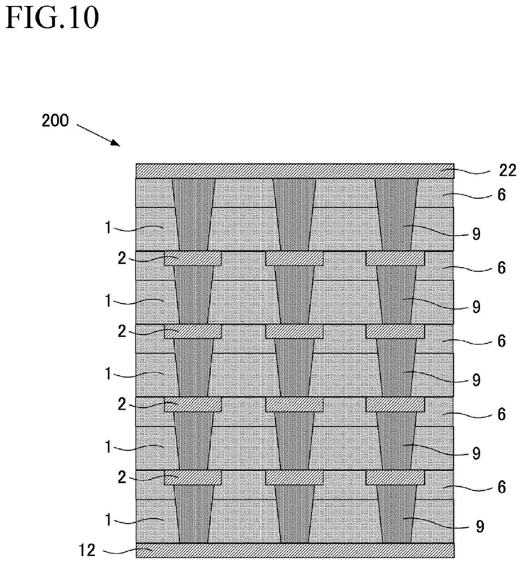

Then, the stacked multiple third laminated bodies 100 are subjected to thermocompression bonding (Fig. 10). Thus, the metal layer 2 of the one third laminated body 100 is embedded in the second insulating substrate 6 of the other third laminated body 100. In addition, the conductive paste 9 is cured. Moreover, the second insulating substrate 6 is completely cured. That is, the second insulating substrate 6 is cured to the C stage.

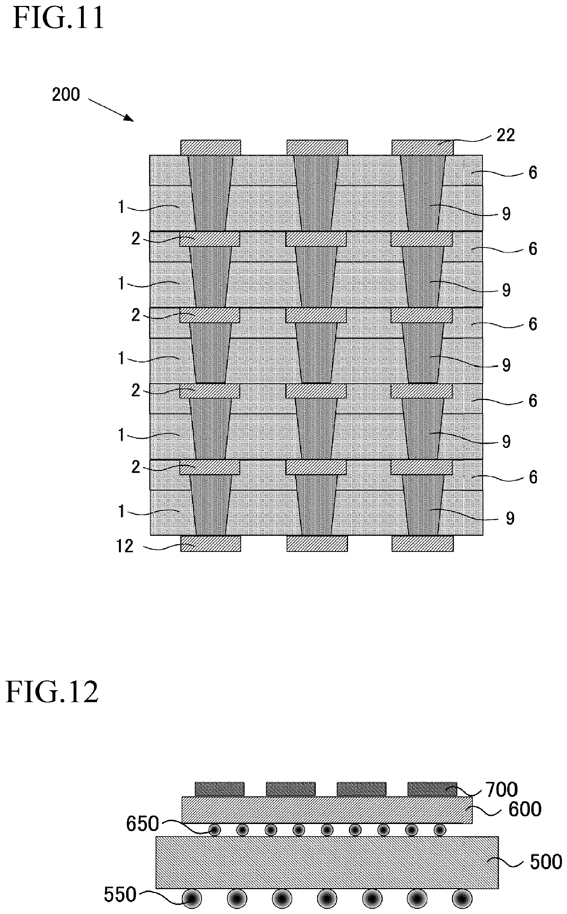

Thereafter, the metal layer 12 and the metal layer 22 are processed into a pattern shape (Fig. 11).

This completes a circuit board.

Each of the circuit board that is formed by the disclosed method for manufacturing the circuit board and the disclosed circuit board, can also be used as a motherboard (support board) or an interposer (relay board), or moreover, a circuit board for constituting a semiconductor element.

Fig. 12 shows a schematic sectional view of a semiconductor package. Fig. 12 shows a semiconductor package that includes a motherboard 500 having solder balls 550, an interposer 600 connected on the motherboard 500 via bumps 650, and semiconductor elements 700 disposed on the interposer 600. An example of the semiconductor element 700 includes a field programmable gate array (FPGA) chip.

Each of the circuit board that is formed by the disclosed method for manufacturing the circuit board and the disclosed circuit board, can also be used as the motherboard 500, the interposer 600, or moreover, a circuit board for constituting the semiconductor element 700, in Fig. 12.

In relation to the embodiment described above, the following supplementary notes are further disclosed.

### (Supplementary Note 1)

A method for manufacturing a circuit board, characterized by comprising:
a process of obtaining a second laminated body by laminating, in this order, an uncured second insulating substrate and a resin film on a second surface opposite to a first surface of a cured first insulating substrate of a first laminated body, and performing thermocompression bonding thereon, the first laminated body including the first insulating substrate and a metal layer that is formed into a pattern shape on the first surface of the first insulating substrate;
a process of obtaining a third laminated body by forming a hole that reaches the metal layer, in the resin film, the second insulating substrate, and the first insulating substrate, from a resin film side of the second laminated body, filling conductive paste into the hole, and then peeling off the resin film; and
a process of performing thermocompression bonding by stacking one third laminated body and another third laminated body in such a manner that the metal layer of the one third laminated body faces an opening of the hole of the another third laminated body.

### (Supplementary Note 2)

The method for manufacturing the circuit board according to Supplementary Note 1, wherein the first insulating substrate is a glass epoxy substrate, and
the second insulating substrate is a glass epoxy substrate.

### (Supplementary Note 3)

The method for manufacturing the circuit board according to Supplementary Note 2, wherein the glass epoxy substrate as the first insulating substrate and the glass epoxy substrate as the second insulating substrate are the same glass epoxy substrates.

### (Supplementary Note 4)

The method for manufacturing the circuit board according to Supplementary Note 1, wherein a material of the second insulating substrate is thermosetting resin that is selected from a group consisting of fluorocarbon resin, polyphenylene ether resin, polyimide resin, and bismaleimide-triazine resin.

### (Supplementary Note 5)

The method for manufacturing the circuit board according to any one of Supplementary Notes 1 to 4, wherein, in performing thermocompression bonding on the one third laminated body and the another third laminated body, the metal layer of the one third laminated body is embedded in the second insulating substrate of the another third laminated body.

### (Supplementary Note 6)

The method for manufacturing the circuit board according to any one of Supplementary Notes 1 to 5, further comprising a process of curing a surface of the conductive paste that protrudes from the hole in the third laminated body.

### (Supplementary Note 7)

The method for manufacturing the circuit board according to any one of Supplementary Notes 1 to 6, wherein, in performing thermocompression bonding by stacking the one third laminated body and the another third laminated body in such a manner that the metal layer of the one third laminated body faces the opening of the hole of the another third laminated body, the second insulating substrate is completely cured.

### (Supplementary Note 8)

A circuit board characterized by comprising multiple laminated bodies, each of the laminated bodies including
a cured first insulating substrate,
a metal layer being formed into a pattern shape on a first surface of the first insulating substrate,
a cured second insulating substrate being disposed on a second surface opposite to the first surface of the first insulating substrate, and
a via being formed to reach the metal layer from a surface opposite to a first insulating substrate side of the second insulating substrate,
among the multiple laminated bodies, one laminated body and another laminated body being positioned in such a manner that the metal layer of the one laminated body faces the via that is exposed at the surface of the second insulating substrate of the another laminated body.

### (Supplementary Note 9)

The circuit board according to Supplementary Note 8, wherein the first insulating substrate is a glass epoxy substrate, and
the second insulating substrate is a glass epoxy substrate.

### (Supplementary Note 10)

The circuit board according to Supplementary Note 9, wherein the glass epoxy substrate as the first insulating substrate and the glass epoxy substrate as the second insulating substrate are the same glass epoxy substrates.

### (Supplementary Note 11)

The method for manufacturing the circuit board according to Supplementary Note 8, wherein a material of the second insulating substrate is a cured substance of thermosetting resin that is selected from a group consisting of fluorocarbon resin, polyphenylene ether resin, polyimide resin, and bismaleimide-triazine resin.

### (Supplementary Note 12)

The circuit board according to any one of Supplementary Notes 8 to 11, wherein the metal layer of the one third laminated body is embedded in the second insulating substrate of the another third laminated body.

### (Supplementary Note 13)

An electronic device characterized by comprising the circuit board according to any one of Supplementary Notes 1 to 7 and an electronic component.

## Claims

1. A method for manufacturing a circuit board, **characterized by** comprising:
a process of obtaining a second laminated body by laminating, in this order, an uncured second insulating substrate and a resin film on a second surface opposite to a first surface of a cured first insulating substrate of a first laminated body, and performing thermocompression bonding thereon, the first laminated body including the first insulating substrate and a metal layer that is formed into a pattern shape on the first surface of the first insulating substrate;
a process of obtaining a third laminated body by forming a hole that reaches the metal layer, in the resin film, the second insulating substrate, and the first insulating substrate, from a resin film side of the second laminated body, filling conductive paste into the hole, and then peeling off the resin film; and
a process of performing thermocompression bonding by stacking one third laminated body and another third laminated body in such a manner that the metal layer of the one third laminated body faces an opening of the hole of the another third laminated body.

2. The method for manufacturing the circuit board according to claim 1, wherein the first insulating substrate is a glass epoxy substrate, and
the second insulating substrate is a glass epoxy substrate.

3. The method for manufacturing the circuit board according to claim 2, wherein the glass epoxy substrate as the first insulating substrate and the glass epoxy substrate as the second insulating substrate are the same glass epoxy substrates.

4. The method for manufacturing the circuit board according to claim 1, wherein a material of the second insulating substrate is thermosetting resin that is selected from a group consisting of fluorocarbon resin, polyphenylene ether resin, polyimide resin, and bismaleimide-triazine resin.

5. The method for manufacturing the circuit board according to any one of claims 1 to 4, wherein, in performing thermocompression bonding on the one third laminated body and the another third laminated body, the metal layer of the one third laminated body is embedded in the second insulating substrate of the another third laminated body.

6. The method for manufacturing the circuit board according to any one of claims 1 to 5, further comprising a process of curing a surface of the conductive paste that protrudes from the hole in the third laminated body.

7. The method for manufacturing the circuit board according to any one of claims 1 to 6, wherein, in performing thermocompression bonding by stacking the one third laminated body and the another third laminated body in such a manner that the metal layer of the one third laminated body faces the opening of the hole of the another third laminated body, the second insulating substrate is completely cured.

8. A circuit board **characterized by** comprising multiple laminated bodies, each of the laminated bodies including
a cured first insulating substrate,
a metal layer being formed into a pattern shape on a first surface of the first insulating substrate,
a cured second insulating substrate being disposed on a second surface opposite to the first surface of the first insulating substrate, and
a via being formed to reach the metal layer from a surface opposite to a first insulating substrate side of the second insulating substrate,
among the multiple laminated bodies, one laminated body and another laminated body being positioned in such a manner that the metal layer of the one laminated body faces the via that is exposed at the surface of the second insulating substrate of the another laminated body.

9. An electronic device **characterized by** comprising the circuit board according to any one of claims 1 to 7 and an electronic component.
